# EUROPEAN PATENT SPECIFICATION

(11) **EP 4 223 716 B1**
(45) Date of publication and mention of the grant of the patent: **09.04.2025**
(21) Application number: 22869044.2
(22) Date of filing: 01.09.2022
(51) Int. Cl.: C03C 23/00, C03C 10/12, C03C 10/04, C03C 10/14, C03C 21/00, C03C 17/34, B32B 17/00, C03C 27/06, C03C 10/00

(54) **ELECTRONIC DEVICE COMPRISING A GLASS SHEET**
ELEKTRONISCHE VORRICHTUNG UMFASSEND EINE GLASSCHEIBE
DISPOSITIF ÉLECTRONIQUE COMPRENANT UNE PLAQUE DU VERRE

(30) Priority: 16.09.2021 CN 202111087497
(43) Date of publication of application: 09.08.2023
(73) Proprietor: Honor Device Co., Ltd., Shenzhen, Guangdong 518040 (CN)
(72) Inventor: CHEN, Qiuqun, Shenzhen, Guangdong 518040 (CN); XU, Wenbin, Shenzhen, Guangdong 518040 (CN)
(74) Representative: Körber, Martin Hans
(86) International application number: PCT/CN2022/116615
(87) International publication number: WO 2023/040673

(56) References cited:
- CN-A- 1 579 976
- CN-A- 102 162 132
- CN-A- 106 746 743
- CN-A- 106 892 562
- CN-A- 111 393 032
- US-A1- 2021 070 018
- US-A1- 2021 230 049

## Description

### TECHNICAL FIELD

This application relates to an electronic device as described in the appended claims.

### BACKGROUND

Currently, screen covers and back covers (also referred to as battery covers or housings) of electronic devices (such as mobile phones) are made of glass on a large scale. However, glass is a brittle material. When a mobile phone falls, a screen cover or a back cover is fragile under impact of a ground, which affects consumer experience.

A strength of the glass cover mainly depends on a fracture toughness and a chemical strengthening stress intensity of glass. To improve anti-drop performance of the glass cover, cover glass in the industry has been developed from aluminum-silicon single strength glass to lithium-aluminum-silicon double strength glass. With the increase of a strengthening depth and a deep compressive stress, puncture resistance of the cover to a rough ground is improved. To improve the fracture toughness of glass, the industry has begun to introduce glass-ceramics. Crystals in the glass-ceramics can resist and change a direction of crack propagation, which significantly improves the anti-drop performance of the cover. A conventional method for manufacturing a chemically-strengthened glass-ceramic cover generally includes: first performing thermal treatment and nucleation and crystallization on a glass precursor to obtain glass-ceramics, and then performing polishing, washing with strong alkali, and chemical strengthening on the glass-ceramics to obtain the chemically-strengthened glass-ceramic cover. However, crystals are evenly distributed in the existing glass-ceramic cover. In a chemical strengthening process, in addition to ion exchange of a glass phase, a microcrystalline phase distributed in the glass-ceramics, especially a microcrystalline phase on a surface layer of the glass-ceramics, also takes part in the ion exchange, and hinders the ion exchange in the chemical strengthening process, which is not conducive to stress enhancement of the surface layer and stress monitoring of a chemically strengthened layer. In addition, in some scenarios, the crystals undergo ion exchange, which changes a crystalline phase of the surface layer and leads to deterioration of chemical properties of the surface layer. In addition, the microcrystalline phase and the glass phase are quite different in physical and chemical properties. The cleaning with strong alkali, chemical strengthening, coating with an anti-fingerprint (Anti-fingerprint, AF) film and a decorative layer (such as ink), an aging test, and the like that are performed on the polished glass-ceramics may easily lead to poor appearance or failure.

In summary, the existing glass-ceramics have many problems during chemical strengthening, and have poor surface processability.

The document CN 106 892 562 A shows a sandwich glass composition.

The document US 2021/070018 A1 shows laminate glass ceramic articles with US-and NIR-blocking characteristics and according methods of manufacture.

The document US 2021/230049 A1 shows an ultrathin glass ceramic article and an according production method.

### SUMMARY

The present invention is defined by the independent claims. The dependent claims show further advantageous developments. According to a first aspect of this application, glass is provided, where the glass includes glass phase layers that are located on a surface layer of the glass and include no crystal, and a glass-ceramic layer that is stacked with the glass phase layers and includes crystals.

The surface layer of the glass is a complete glass phase that includes no crystal. Firstly, the surface layer of the glass has high ion exchange efficiency in a chemical strengthening process, which is conductive to stress enhancement of the surface layer and stress monitoring of a chemically strengthened layer, and increases a surface compressive stress and a strengthening stress depth of the glass; secondly, compared with conventional glass-ceramics, the surface layer of the glass is the complete glass phase, which can further prevent deterioration of chemical properties of the surface layer caused by ion exchange of crystals in a surface layer microcrystalline phase of the conventional glass-ceramics; and thirdly, the surface layer of the glass is the complete glass phase, and surface processability is excellent, which improves stability of properties such as chemical resistance, adhesion of a fingerprint film and a decorative layer (such as ink), and an aging test of the glass. In addition, an interior of the glass is the glass-ceramic layer with a relatively high intrinsic strength, which can resist a central tensile stress and crack propagation, so that the glass has both a high fracture toughness of glass-ceramics and a deep chemically-strengthened stress of glass, and therefore has excellent anti-drop performance.

In some embodiments of this application, an interface between each glass phase layer and the glass-ceramic layer is planar or non-planar. When the interface between the glass phase layer and the glass-ceramic layer is a non-planar curved surface (for example, a wavy surface or a serrated surface), stress expansion in the glass is slowed down, and cracks or defects can be prevented from expanding along the interface between the glass-ceramic layer and the glass phase layer, thereby improving performance of the glass.

In some embodiments of this application, the crystals in the glass-ceramic layer are evenly distributed or unevenly distributed. When the crystals are evenly distributed, processing efficiency is improved; or when the crystals are unevenly distributed, the glass is induced to be asymmetrically distributed. For example, grains in an area of the glass-ceramic layer close to an outer side are large in size and sparse, which is conductive to chemical strengthening of an outer surface of the cover; and grains in an area of the glass-ceramic layer close to an inner side are fine and dense, and has a large proportion of grain boundaries, so that a propagation path is tortuous when cracks break along the grain boundaries, which can increase an internal tensile stress and improve crack resistance.

In some embodiments of this application, the crystals have a size of 5 nm~1 µm. Micron-sized or even nano-sized crystals can resist and change a crack propagation direction. In some embodiments, the crystals are spherical, and the size of a crystal in the glass-ceramic layer means a diameter of the crystal.

In some embodiments of this application, a main crystalline phase in the glass-ceramic layer includes one or more of lithium silicate, a β-quartz solid solution, lithium disilicate, petalite, and a β-spodumene solid solution.

In some embodiments of this application, the glass phase layer includes one or more of Li₂O, Na₂O, and K₂O; and a sum of weight percentages of Li₂O, Na₂O, and K₂O in the glass is 5%~18%.

In some embodiments of this application, the glass-ceramic layer has a thickness less than or equal to 50 µm. It should be noted that the glass-ceramic layer having a thickness less than or equal to 50 µm means a range that a processing capability of a glass-ceramic material can reach. An excessively small thickness of the glass-ceramic layer is not conducive to crack resistance at a central position of the glass; and an excessively large thickness of the glass-ceramic layer is not conducive to surface layer strengthening of the glass.

In some embodiments of this application, the glass-ceramic layer has a crystallinity greater than 80%, and the glass-ceramic layer has a Young's modulus greater than or equal to 90 GPa.

In some embodiments of this application, the glass is a glass sheet, and the glass includes two glass phase layers in a thickness direction of the glass; and the glass-ceramic layer is located between the two glass phase layers.

In some embodiments of this application, the glass-ceramic layer is located at a central position of the glass in the thickness direction of the glass; or the glass-ceramic layer deviates from the central position of the glass in the thickness direction of the glass.

In some embodiments of this application, the glass has a 2D shape, a 2.5D shape, or a 3D shape.

In some embodiments of this application, a thickness of the glass is defined as t, where t is 0.1~1 mm.

In some embodiments of this application, the glass-ceramic layer has a thickness greater than or equal to 0.99t; or the glass-ceramic layer has a thickness of 0.5t~0.9t.

In some embodiments of this application, the glass has a depth of a chemically strengthened layer of 3~10 µm, the glass has a depth of compression of 0.14t~0.23t, and the glass has a surface compressive stress of 600~1000 Mpa.

According to a second aspect of this application, a glass member is provided, where the glass member includes the foregoing glass.

Because the glass member includes the foregoing glass, the glass member can resolve many problems existing in existing glass-ceramics during chemical strengthening, and have better surface processability.

In some embodiments of this application, the glass member further includes an anti-fingerprint film and/or a decorative layer arranged on a surface of the glass.

According to a third aspect of this application, an electronic device is provided, where the electronic device includes a screen cover and a housing, and at least one of the screen cover and the housing includes the foregoing glass.

Because the at least one of the screen cover and the housing of the electronic device includes the foregoing glass, the electronic device has an excellent overall anti-drop level.

According to a fourth aspect of this application, a method for preparing glass is provided, where the method includes:
crystallizing an uncrystallized glass precursor by a femtosecond laser to obtain glass,
where the glass includes glass phase layers that is located on a surface layer of the glass and includes no crystal, and a glass-ceramic layer that is stacked with the glass phase layers and includes crystals.

According to the method for preparing glass, continuous irradiation of the femtosecond laser on the uncrystallized glass precursor produces a heat accumulation effect, so that the uncrystallized glass precursor in a laser focal area is heated and melted, and then crystals precipitate through nucleation and growth. The femtosecond laser technology is used to selectively induce crystal growth in a three-dimensional space inside the glass, and then form the internal glass-ceramic layer and the external glass phase layers.

In some embodiments of this application, the step of crystallization includes: controlling a thickness of the glass-ceramic layer, a position of the glass-ceramic layer in the glass, and/or a shape of an interface between each glass phase layer and the glass-ceramic layer by adjusting a laser path of the femtosecond laser.

In some embodiments of this application, the step of crystallization includes: controlling a size of the crystals and/or a density distribution of the crystals in the glass-ceramic layer by adjusting a power density and/or a scanning speed of the femtosecond laser.

In some embodiments of this application, the femtosecond laser has a pulse width of 30 fs~1 ps, the femtosecond laser has a wavelength of 780 nm~1.5 µm, a laser focal area of the femtosecond laser has a power density greater than 10¹⁴ W/cm², and the femtosecond laser has a repetition frequency of 200 kHz~500 MHz.

In some embodiments of this application, the method further includes: performing chemical strengthening treatment on the uncrystallized glass precursor before the crystallization; or performing chemical strengthening treatment on the crystallized glass precursor.

In some embodiments of this application, the strengthening treatment includes two ion exchanges:
the first ion exchange: a composition of a molten salt being pure NaNO₃ or a mixture of NaNO₃ and KNO₃, with content of NaNO₃ ≥ 50wt%, and the molten salt being at a temperature of 380°C~450°C; and
the second ion exchange: a composition of a molten salt being pure KNO₃ or a mixture of NaNO₃ and KNO₃, with content of KNO₃ ≥ 80wt%, and the molten salt being at a temperature of 380°C~450°C.

In some embodiments of this application, the method for preparing glass further includes:
performing hot bending treatment on the uncrystallized glass precursor before the crystallization; or performing hot bending treatment on the crystallized glass precursor.

In some embodiments of this application, the method for preparing glass further includes:
polishing the glass precursor after the hot bending treatment.

According to a fifth aspect of this application, a method for preparing a glass member is provided, where the method includes the foregoing method for preparing glass; and arranging an anti-fingerprint film and/or a decorative layer on a surface of the glass.

The method for preparing a glass member includes the foregoing method for preparing glass. Therefore, the obtained glass has better surface processability, and the formed anti-fingerprint film and/or decorative layer have/has good adhesion.

### BRIEF DESCRIPTION OF DRAWINGS

FIG. 1 is a curve graph of a measured stress of glass according to some embodiments of this application;
FIG. 2 is a schematic diagram of a structure of glass according to some embodiments of this application;
FIG. 3 is a schematic diagram of a cross section taken along line A-A in FIG. 2;
FIG. 4 to FIG. 7 are schematic diagrams of a structure of glass according to some modification examples of this application;
FIG. 8 is a schematic diagram of a 2D shape, a 2.5D shape, and a 3D shape;
FIG. 9 is a schematic diagram of a structure showing crystallization of an uncrystallized glass precursor by a femtosecond laser;
FIG. 10 is a schematic flowchart of a method for preparing glass according to some embodiments of this application;
FIG. 11 is a schematic flowchart of a method for preparing glass according to some other embodiments of this application; and
FIG. 12 is a schematic diagram of a structure of an electronic device according to some embodiments of this application.

### Description of reference signs of main components

| | |
|---|---|
| Electronic device | 100 |
| Screen cover | 10 |
| Housing | 30 |
| Glass | 50 |
| Glass phase layer | 51 |
| First glass phase layer | 511 |
| Second glass phase layer | 513 |
| Glass-ceramic layer | 53 |
| Crystal | 531 |
| Uncrystallized glass precursor | 60 |

This application is further described by using the following specific implementations with reference to the foregoing accompanying drawings.

### DESCRIPTION OF EMBODIMENTS

Unless otherwise specified, data range values described in embodiments of this application shall include end values.

Glass according to the embodiments of this application may be applied to an electronic device. For example, the glass is applied to a screen cover and a back cover (also referred to as a battery cover or a housing) of a mobile phone. It should be understood that the glass according to the embodiments of this application may be further applied to other occasions. For example, the glass may be applied to vehicle products (for example, a vehicle lampshade, a windshield, or in-vehicle dashboard glass), building products, and appliance products.

To facilitate understanding of the solutions in the embodiments of this application, the concepts and related technologies used in this application are first described.

Glass-ceramics (glass-ceramics) are a material that includes both a microcrystalline phase and a glass phase and is obtained by controlling crystallization of glass in a manufacturing process. A glass matrix and microcrystalline particles dispersed therein can be observed by using a scanning electron microscope (scanning electron microscope, SEM) or a transmission electron microscope (transmission electron microscope, TEM). Glass-ceramics are generally opaque, but when the crystal particles are smaller than a wavelength of visible light (for example, less than 300 nm), transparent glass-ceramics may be obtained. Based on a crystalline phase of glass-ceramics, the glass-ceramics can achieve a higher fracture toughness than glass, thereby increasing a strength of a cover product. The transparent glass-ceramics has advantages such as high transparency of glass and high strength of ceramics, which provides an effective way to improve anti-drop performance of an ultra-thin glass cover. After chemical strengthening of glass-ceramics, and through the improvement of the fracture toughness by microcrystalline grains, chemically strengthened transparent glass-ceramics become a material very suitable for a cover of an electronic device (such as a mobile phone).

Chemical strengthening: Generally, an ion exchange method is used for strengthening. Ion exchange is to immerse glass in an alkali metal molten salt filled with relatively large-radius ions. At a glass transition temperature point Tg of the glass, large-radius alkali metal ions (for example, sodium ions and potassium ions) in the molten salt are exchanged with small-radius alkali metals (for example, sodium ions and lithium ions) in a glass surface through ion exchange. After the ion exchange, because of a volume difference between the glass and the molten salt, the glass surface presents a compressive stress state. Generally, a larger depth of compression is more helpful to improvement of anti-drop performance of the glass.

Surface compressive stress (compressive stress, CS): This generally means a maximum compressive stress formed by chemically strengthened glass on the glass surface, and is used to protect the glass surface and prevent surface defects from developing into cracks.

Inflection point stress (CSk): a stress of transition between first chemical strengthening and second chemical strengthening. Generally, the first chemical strengthening is mainly to replace lithium ions in the glass with sodium ions in the molten salt, and the second chemical strengthening is mainly to replace sodium ions in the glass with potassium ions in the molten salt. Generally, the potassium ions define a peak of stress distribution, while the sodium ions define a deep tail of the distribution. A point at which the peak and the tail of the stress distribution meet is referred to as an inflection point stress.

Central tension (central tension, CT): Due to a requirement of stress balance, a surface compressive stress and a central tension of chemical strengthening must be in a balanced state. Due to existence of the central tension, a DOC generally has a maximum value, because a thickness of a tension layer of the material needs to be ensured.

Depth of a chemically strengthened layer (depth of layer, DOL): This generally means a depth at which reinforcing ions (for example, potassium ions used to strengthen sodium glass) used in chemically strengthened glass diffuse into the glass. Hereinafter, this is also referred to as a depth of a potassium (K) layer and a thickness of the potassium (K) layer.

Depth of compression (depth of compression, DOC): This generally means a thickness of a compressive stress layer of chemically strengthened glass, that is, a distance from the surface (the position at which the compressive stress is maximum) to the position at which the compressive stress is zero. When the DOL is relatively small (for example, DOL < 0.1t, where t indicates a thickness), the DOC and the DOL are basically the same, but with the gradual increase of the DOL, a difference between the DOC and the DOL becomes increasingly larger.

Intrinsic strength: This is a theoretical strength and means a capability of a solid material in resisting damage. In the embodiments of this application, the intrinsic strength means a fracture strength.

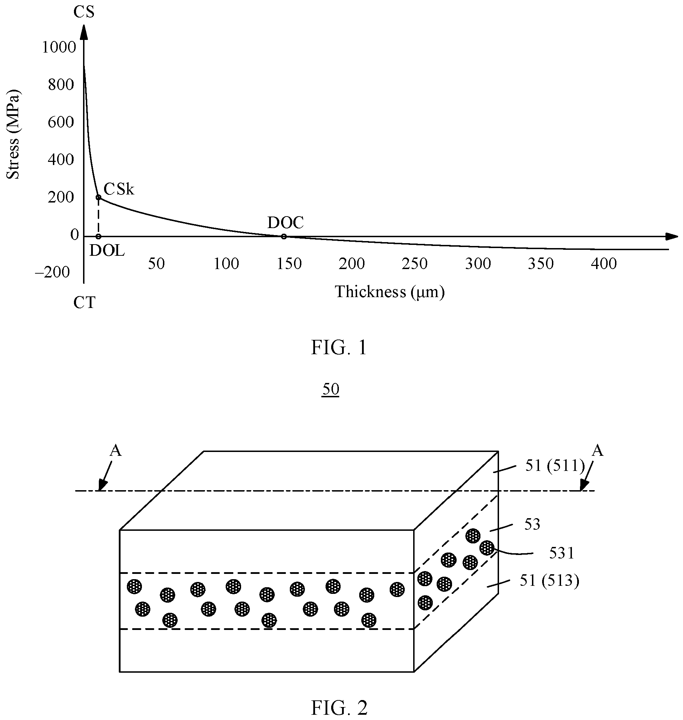

A relationship between the foregoing surface compressive stress CS, inflection point stress CSk, central tension CT, depth of a chemically strengthened layer DOL, and depth of compression DOC may be shown in FIG. 1.

An embodiment of this application provides glass, where the glass includes glass phase layers that is located on a surface layer of the glass and includes no crystal, and a glass-ceramic layer that is stacked with the glass phase layers and includes crystals. It should be noted that, in this application, the glass phase layer is an amorphous solid with a random structure, and internally includes no crystal.

In the glass according to this embodiment of this application, the surface layer of the glass is a complete glass phase that includes no crystal. Compared with common glass-ceramics, the surface layer of the glass has high polishing efficiency and high ion exchange efficiency in a chemical strengthening process, which is conductive to stress enhancement of the surface layer and stress monitoring of a chemically strengthened layer, and increases a surface compressive stress and a strengthening stress depth of the glass; and an interior of the glass is the glass-ceramic layer with a relatively high intrinsic strength, which can resist a central tensile stress and crack propagation, so that the glass has both a high fracture toughness of glass-ceramics and a deep chemically-strengthened stress of glass, and has excellent anti-drop performance. In addition, in the glass according to this embodiment of this application, the surface layer of the glass is a homogeneous glass phase, which, compared with conventional glass-ceramics, prevents deterioration of chemical properties of the surface layer caused by ion exchange of crystals in a surface layer microcrystalline phase; and surface processability is excellent, which improves stability of properties such as chemical resistance, adhesion of a fingerprint film and a decorative layer (such as ink), and an aging test of the glass.

Technical solutions in the embodiments of this application are described below with reference to the accompanying drawings in the embodiments of this application. It should be noted that an example in which the glass is in the form of a glass sheet is used for description below. It can be understood that glass may alternatively be in another form, such as a glass ball or a glass block.

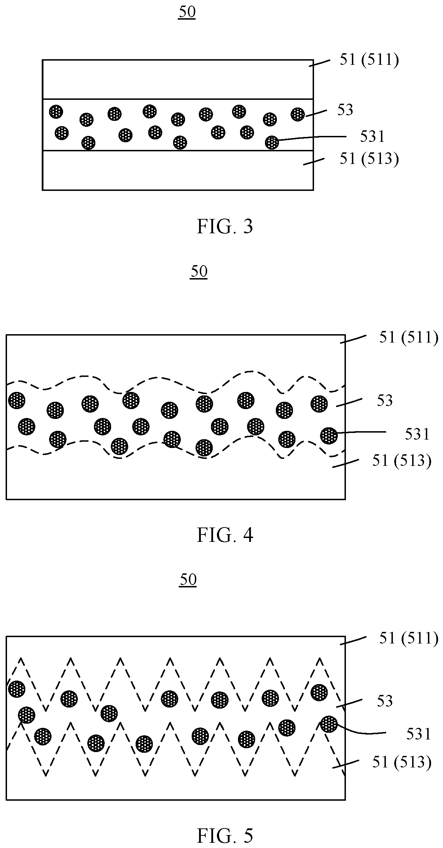

As shown in FIG. 2 and FIG. 3, glass 50 includes glass phase layers 51 and a glass-ceramic layer 53 that includes crystals 531 and is stacked with the glass phase layers 51. The glass phase layers 51 are located at a surface layer of the glass 50. In FIG. 2 and FIG. 3, the glass 50 includes two glass phase layers 51 (a first glass phase layer 511 and a second glass phase layer 513) in a thickness direction of the glass 50. The glass-ceramic layer 53 is located between the two glass phase layers 51. In another embodiment, the glass 50 includes a glass phase layer 51 and a glass-ceramic layer 53 located on a side of the glass phase layer 51.

A thickness of the glass 50 is defined as t. In some embodiments, the glass 50 is applied to a screen cover and/or a housing of an electronic device (including a mobile phone, a tablet computer, a computer, or the like), and t is 0.1~1 mm. That is, the glass 50 has, within an ultra-thin thickness of 0.1~1 mm, a structure with both the glass phase layer 51 and the glass-ceramic layer 53. Preferably, the thickness t is 0.5~0.7 mm, such as 0.5 mm, 0.55 mm, 0.6 mm, 0.65 mm, or 0.7 mm. In addition, to ensure performance of the material, depending on the strengthening level, preferable, the thickness range of the glass phase layers 51 on two sides is 120~200 µm, such as 120~130 µm, 130~140 µm, 140~150 µm, 150~160 µm, 160~170 µm, 170~180 µm, 180~190 µm, or 190~200 µm.

In some other embodiments, the glass 50 is applied to another device with glass, such as a building product (for example, building glass); a vehicle product (for example, a windshield or in-vehicle dashboard glass), an appliance product, or any product that requires a certain degree of transparency, scratch resistance, and abrasion resistance or a combination thereof, and t is 3~7 mm.

In some embodiments of this application, the glass-ceramic layer 53 has a thickness less than or equal to 50 µm. For example, the glass-ceramic layer 53 may have a thickness of 10 µm, 15 µm, 20 µm, 25 µm, 30 µm, 35 µm, 40 µm, 45 µm, or 50 µm. In some other embodiments of this application, the glass-ceramic layer 53 has a thickness greater than or equal to 0.99t. It should be noted that the glass-ceramic layer 53 having a thickness less than or equal to 50 µm and the glass-ceramic layer 53 having a thickness greater than or equal to 0.99t means a range that a processing capability of a glass-ceramic material can reach. An excessively small thickness of the glass-ceramic layer 53 is not conducive to crack resistance at a central position of the glass; and an excessively large thickness of the glass-ceramic layer 53 is not conducive to surface layer strengthening of the glass. Preferably, the glass-ceramic layer 53 has a thickness greater than 50 µm and less than 0.99t. Particularly, the glass-ceramic layer 53 has a thickness of 0.5t~0.9t; that is, a microcrystalline phase is in most of the distribution in the thickness direction of the glass 50, to improve the fracture toughness of the glass, so as to improve anti-drop performance of the glass. For example, the glass 50 has a thickness t of 0.7 mm, and the glass-ceramic layer 53 has a thickness of 0.35~0.6 mm, preferably 0.4~0.5 mm. The glass 50 has a thickness t of 0.5 mm, and the glass-ceramic layer 53 has a thickness of 0.25~0.45 mm, preferably 0.3~0.4 mm. The glass 50 has a thickness t of 0.6 mm, and the glass-ceramic layer 53 has a thickness of 0.3~0.54 mm, preferably 0.3~0.5 mm.

In some embodiments of this application, as shown in FIG. 2 and FIG. 3, an interface between each glass phase layer 51 and the glass-ceramic layer 53 is planar. In some other embodiments of this application, as shown in FIG. 4 and FIG. 5, an interface between each glass phase layer 51 and the glass-ceramic layer 53 is non-planar. Specifically, in FIG. 4, the interface between the glass phase layer 51 and the glass-ceramic layer 53 is a wavy surface with peaks and valleys connected in sequence. In FIG. 5, an interface between each glass phase layer 51 and the glass-ceramic layer 53 is a serrated surface. Alternatively, an interface between each glass phase layer 51 and the glass-ceramic layer 53 may be a wrapping surface in any form. When the interface between the glass phase layer 51 and the glass-ceramic layer 53 is non-planar (for example, a wavy surface or a serrated surface), stress expansion in the glass 50 is slowed down, cracks or defects can be prevented from expanding along the interface between the glass-ceramic layer 53 and the glass phase layer 51, thereby improving performance of the glass.

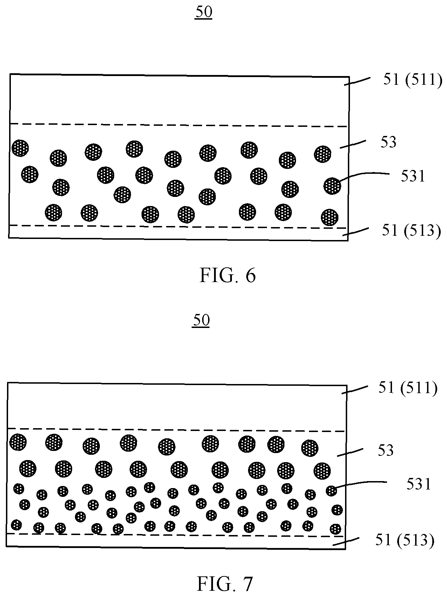

In some embodiments of this application, as shown in FIG. 3 to FIG. 5, the glass-ceramic layer 53 is located at a central position of the glass 50 in the thickness direction of the glass 50. In some other embodiments of this application, as shown in FIG. 6, the glass-ceramic layer 53 deviates from the central position of the glass 50 in the thickness direction of the glass 50.

In some embodiments of this application, a main crystalline phase in the glass-ceramic layer 53 includes one or more of lithium silicate, a β-quartz solid solution, lithium disilicate, petalite, and a β-spodumene solid solution. The crystals 531 in the glass-ceramic layer 53 have a size of 5 nm~1 µm. For example, the crystals 531 in the glass-ceramic layer 53 have a size of 5~50 nm, 50~100 nm, 100~150 nm, 150~200 nm, 200~250 nm, 250~300 nm, 300~350 nm, 350~400 nm, 400~450 nm, 450~500 nm, 500~550 nm, 550~600 nm, 600~650 nm, 650~700 nm, 700~750 nm, 750~800 nm, 800~850 nm, 850~900 nm, 900~950 nm, or 950 nm~1 µm.

In some embodiments, preferably, the crystals 531 have a size of 5~50 nm, and the crystals 531 have a size of, for example, 5~10 nm, 10~15 nm, 15~20 nm, 20~25 nm, 25~30 nm, 30~35 nm, 35~40 nm, 40~45 nm, or 45~50 nm. Micro-sized or even nano-sized crystals can resist and change a crack propagation direction. In some embodiments, the crystals 531 are spherical, and the size of a crystal 531 in the glass-ceramic layer 53 means a diameter of the crystal 53.

In some embodiments of this application, as shown in FIG. 3 to FIG. 6, the crystals 531 in the glass-ceramic layer 53 are evenly distributed. In some other embodiments of this application, as shown in FIG. 7, the crystals 531 in the glass-ceramic layer 53 are unevenly distributed. Specifically, in FIG. 7, the crystals 531 on a side of the glass-ceramic layer 53 close to the first glass phase layer 511 are relatively large in size, and the crystals 531 on a side of the glass-ceramic layer 53 close to the second glass phase layer 513 are relatively small in size. In another embodiment, the crystals 531 in the glass-ceramic layer 53 may be distributed in any size. When the crystals 531 are relatively small in size and are evenly distributed, processing efficiency is improved; or when the crystals 531 are unevenly distributed, the glass 50 is induced to be asymmetrically distributed. Specifically, the crystals 531 on the side of the glass-ceramic layer 53 close to the first glass phase layer 511 are relatively large in size, which is conductive to chemical strengthening for scratch resistance; and the crystals 531 on the side of the glass-ceramic layer 53 close to the second glass phase layer 513 are relatively small in size, which is conductive to impact resistance and crack resistance. In addition, the size of the crystals 531 may be controlled by adjusting a laser induced rate. Because a low laser induced rate is conductive to crystal growth, a low laser induced rate may be used in an area with a large crystal size, and a high laser induced rate may be used in an area with a small crystal size.

In some embodiments of this application, the glass 50 is applied to a cover of an electronic device (such as a mobile phone). The glass-ceramic layer 53 is shifted toward an inner side (the side away from a user's touch surface) and/or an outer side (the side close to the user's touch surface) of the cover. When the glass-ceramic layer 53 is shifted toward the inner side, the inner side of the cover has a relatively high fracture toughness. When the glass-ceramic layer 53 is shifted toward the outer side, chemical strengthening of the outer side of the cover is facilitated, so that after the chemical strengthening, an outer stress is high, a central tensile stress is shifted toward the inner side, and thus it is not easy to pierce an outer stress layer when the cover drops on a rough ground, which improves the overall anti-drop level of the cover. In addition, because the inner side of the cover is mainly subjected to a tensile stress when the cover is impacted, grains in an area of the glass-ceramic layer 53 close to the outer side are large in size and sparse, which is conductive to chemical strengthening of an outer surface of the cover; and grains in an area of the glass-ceramic layer 53 close to the inner side of the cover are fine and dense, and has a large proportion of grain boundaries, so that a propagation path is tortuous when cracks break along the grain boundaries, which can increase an internal tensile stress and improve crack resistance.

In some embodiments of this application, the integrally crystallized glass-ceramics prepared based on the crystalline phase of the glass-ceramic layer 53 has a crystallinity greater than 80%, and the glass-ceramic layer 53 has a Young's modulus greater than or equal to 90 GPa. Specifically, the integrally crystallized glass-ceramics prepared based on the crystalline phase of the glass-ceramic layer 53 has a crystallinity of 90%~95%, and the glass-ceramic layer 53 has a Young's modulus greater than or equal to 95~105 GPa. Therefore, the glass 50 including the glass-ceramic layer 53 can resist the strengthened central tensile stress and crack propagation, thereby improving the chemical strengthening and anti-drop level.

In some embodiments of this application, the glass phase layer 51 includes one or more of Li₂O, Na₂O, and K₂O, and a sum of weight percentages of Li₂O, Na₂O, and K₂O in the glass 50 is 5%~18%. Preferably, the weight percentage of Li₂O in the glass 50 is 4%~13%, the weight percentage of Na₂O in the glass 50 is 05%~3.5%, and the weight percentage of K₂O in the glass 50 is 0.5%~1.5%.

In some embodiments of this application, the glass 50 may be chemically strengthened through Na/Li exchange and Na/K exchange. A film stress measurement (Film Stress Measurement, FSM) instrument is used to monitor a stress and a depth of a K layer. After the Na/K exchange, the depth of a chemically strengthened layer DOL (a depth of the K layer and a thickness of the K layer) of the glass 50 measured through the FSM is 3~10 µm, the depth of compression DOC of the glass 50 is 0.14t~0.23t, and the surface compressive stress CS of the glass 50 is 600~1000 MPa, which can keep the surface stress and strengthening depth of the cover and has relatively high scratch resistance. Preferably, after the Na/K exchange, the glass 50 has a depth of the chemically strengthened layer DOL (the depth of the K layer and the thickness of the K layer) of 6~8 µm (for example, 6~6.5 µm, 6.5~7 µm, 7~7.5 µm, or 7.5~8 µm), the glass 50 has a depth of compression DOC of 0.16t~0.18t (for example, 0.16t, 0.17t, or 0.18t), and the glass 50 has a surface compressive stress CS of 780~950 MPa (for example, 780~800 Mpa, 800~850 MPa, 850~900 MPa, or 900~950 MPa).

In an embodiment of this application, a curve of a stress of the glass 50 measured through the FSM is shown in FIG. 1, with the horizontal coordinate indicating a thickness of the glass (in µm) and the vertical coordinate indicating a stress value of the glass (in MPa). As shown in FIG. 1, the glass 50 has a thickness greater than 0.4 mm, the glass 50 has a depth of the chemically strengthened layer DOL of 5~10 µm, the glass 50 has a depth of compression DOC greater than 100 µm (about 150 µm in FIG. 1), and the glass 50 has a surface compressive stress CS greater than 800 MPa.

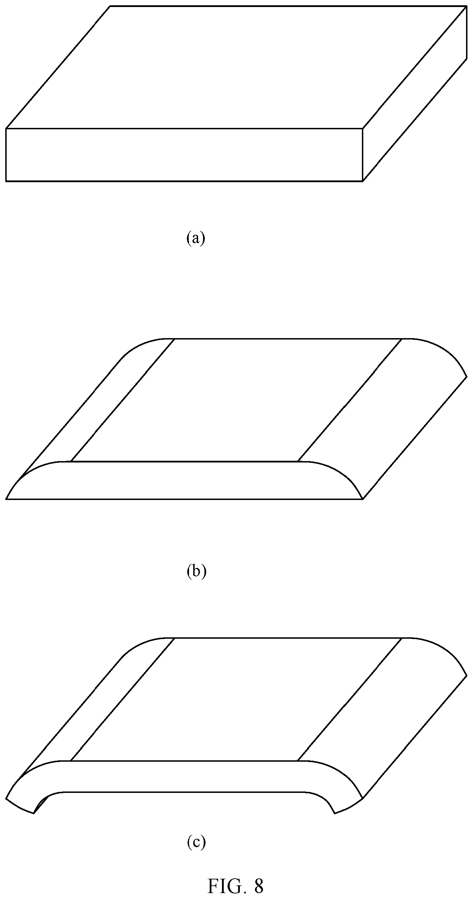

In some embodiments of this application, the glass 50 has a 2D shape, a 2.5D shape, or a 3D shape. (a), (b), and (c) in FIG. 8 are schematic diagrams of a 2D shape, a 2.5D shape, and a 3D shape of glass, respectively. As shown in (a) in FIG. 8, the 2D shape means that the two opposite surfaces of the glass 50 are planar. As shown in (b) in FIG. 8, the 2.5D shape means that one of two opposite surfaces of the glass 50 is a plane, a middle area of the other surface is a plane, and an edge area thereof is a curved surface with a certain radian. As shown in (c) in FIG. 8, the 3D shape means that the glass 50 has a bent three-dimensional structure, and two opposite surfaces thereof are curved surfaces. The glass 50 with a 3D shape is usually formed through hot bending. For the glass 50 with a 2D shape and the glass 50 with a 2.5D shape, hot bending may not be performed.

An embodiment of this application further provides a method for preparing glass, which includes crystallizing an uncrystallized glass precursor by using a femtosecond laser to obtain glass. The glass includes glass phase layers that is located on a surface layer of the glass and includes no crystal, and a glass-ceramic layer that is stacked with the glass phase layers and includes crystals.

In this embodiment of this application, continuous irradiation of the femtosecond laser on the uncrystallized glass precursor produces a heat accumulation effect, so that the uncrystallized glass precursor in a laser focal area is heated and melted, and then nucleates and grows, and precipitates crystals. When the femtosecond laser irradiates the uncrystallized glass precursor, energy thereof is absorbed by the uncrystallized glass precursor by using a nonlinear process such as multiphoton ionization, and the absorbed energy is released in a thermal relaxation mode through collision between electrons and phonons or between phonons and is converted into heat energy. The heat energy diffuses inside the material in a heat conduction mode to form a certain temperature field, thereby leading to a change in glass structure and performance within a focusing range. Generally, a characteristic time for a material to absorb the laser energy and convert the laser energy into the heat energy is usually at a picosecond level. In a subsequent thermal relaxation process, free electrons collide with a crystal lattice to transfer energy to the crystal lattice to form heat release, which will generate a high temperature of thousands of Kelvin. Then, due to thermal diffusion, the temperature usually drops rapidly to normal temperature within 10~6s. When the femtosecond laser with a high repetition frequency greater than 200 kHz is used, a laser pulse interval is less than 5 µs. When the high temperature generated by a previous femtosecond laser pulse does not completely subside due to the thermal diffusion process, a next pulse will inject energy into the glass precursor. In this way, through the continuous injection of the femtosecond laser with a high repetition frequency, a large amount of heat energy accumulated in a short time will cause the temperature of a focal area to rise rapidly. Chemical elements in the glass migrate due to the driving of thermal diffusion, which leads to the continuous accumulation and growth of crystal nuclei. Therefore, the nucleation is first completed at a distance from a focus center, and then the crystals grow continuously from the outside to the inside. Because the crystal growth orientation is related to a temperature gradient of a solid-liquid interface in the glass and a growth rate of the crystals, a relatively mild and uniform temperature field can be formed inside the glass by precisely controlling laser parameters, so that the crystals grow along a certain orientation. Therefore, the femtosecond laser technology is used to selectively induce crystal growth in a three-dimensional space inside the glass. In some embodiments of this application, a three-dimensional platform (not shown) is used to move a laser focus inside the glass precursor, so as to precipitate a microcrystalline phase along a laser path, and then form the internal glass-ceramic layer and the external glass phase layers.

It should be noted that the relaxation process means a process of gradually recovering from a state to an equilibrium state in a gradual physical process. The thermal relaxation process means a process that a system recovers from a metastable state with relatively high energy to a thermodynamic steady state, in which energy of the system is released in a form of heat.

In some embodiments of this application, a thickness of the glass-ceramic layer, a position of the glass-ceramic layer in the glass, and/or a shape of an interface between each glass phase layer and the glass-ceramic layer are controlled by adjusting a laser path of the femtosecond laser. For example, through adjustment of the laser path, the thickness of the glass-ceramic layer may be controlled to be less than or equal to 50 µm, or greater than or equal to 0.99t, or 0.5t~0.9t. For another example, through adjustment of the laser path, the glass-ceramic layer may be controlled to shift toward the inner side or the outer side of the glass, so that in the thickness direction of the glass, the glass-ceramic layer is located at a central position of the glass or deviated from the central position of the glass. For another example, through adjustment of the laser path of the femtosecond laser, the interface between the glass phase layer and the glass-ceramic layer is controlled to be a plane, a curved surface, or a wrapping surface in any form. Therefore, through adjustment the laser path of the femtosecond laser, the thickness and position of the glass-ceramic layer and the shape of the interface with the glass-ceramic layer can be adjusted to improve the fracture toughness of the glass, and prevent cracks or defects from expanding along the interface between the glass-ceramic layer and the glass phase layer, thereby improving performance of the glass.

In some embodiments of this application, a size of the crystals and/or a density distribution of the crystals in the glass-ceramic layer are/is controlled by adjusting a power density and/or a scanning speed of the femtosecond laser. For example, through adjustment of the power density and/or the scanning speed of femtosecond laser, the generation of the glass-ceramic layer is induced, so that the crystals on one side of the glass-ceramic layer are small in size and dense, and the crystals on the other side are large in size and sparse. In the small and dense crystal distribution, a large proportion of grain boundaries are provided, so that a propagation path is tortuous when cracks break along the grain boundaries, which can increase an internal tension and improve crack resistance. The large and sparse crystal distribution is conducive to chemical strengthening of the outer surface.

In some embodiments of this application, the femtosecond laser has a pulse width of 30 fs~1 ps (such as 30~80 fs, 80~150 fs, 150~200 fs, 200~250 fs, 250~300 fs, 300~350 fs, 350~400 fs, 400~450 fs, 450~500 fs, 500~550 fs, 550~600 fs, 350~400 fs, 600~650 fs, 650~700 fs, 700~750 fs, 750~800 fs, 800~850 fs, 850~900 fs, 900~950 fs or 950 fs~1 ps), the femtosecond laser has a wavelength of 780 nm~1.5 µm (near infrared band, such as 780~800 nm, 800~1030 nm, or 1030 nm~1.5 µm), a laser focal area of the femtosecond laser has a power density greater than 10¹⁴W/cm², and the femtosecond laser has a repetition frequency of 200 kHz~500 MHz (such as 200~500 kHz, 500 kHz~1 MHz, 1~100 MHz, 100~200 MHz, 200~300 MHz, 300~400 MHz, or 400~500 MHz). Because the glass precursor has no intrinsic absorption on the near infrared band, and the laser focal area has a great power density, a nonlinear effect such as multiphoton absorption can be implemented, and internal modification of the uncrystallized glass precursor can be implemented. The femtosecond laser has a repetition frequency of 200 kHz~500 MHz. The laser with the high repetition frequency can introduce the next pulse before the energy absorbed by the previous pulse diffuses along the crystal lattice, resulting in a heat accumulation effect and a local temperature field, thereby promoting the nucleation and growth of the crystals at the laser focus. In addition, the three-dimensional platform is used to move the laser focus inside the glass, so as to precipitate a microcrystalline phase along a laser path, and then form the internal glass-ceramic layer and the external glass phase layers. Preferably, the femtosecond laser has a pulse width of 80~150 fs, the femtosecond laser has a wavelength of 800~1030 nm, and the femtosecond laser has a repetition frequency of 500 kHz~1 MHz.

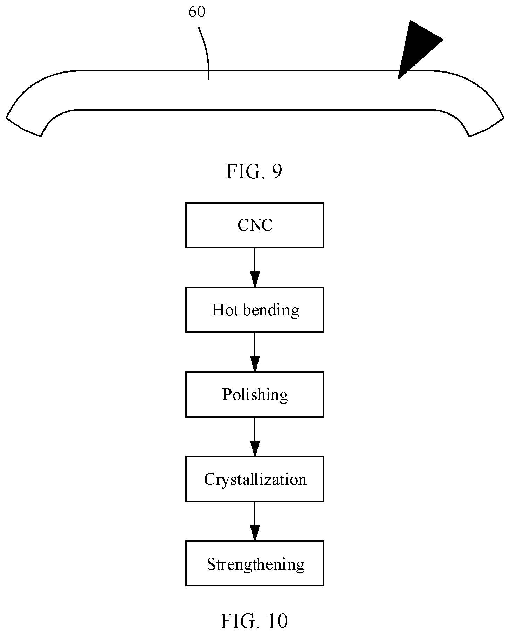

In some embodiments of this application, the method for preparing glass includes, but is not limited to, computerized numerical control (computerized numerical control, CNC) machining, hot bending, polishing, and strengthening, in addition to crystallization by the femtosecond laser. In some embodiments, as shown in FIG. 9, before crystallization by the femtosecond laser, an uncrystallized glass precursor 60 has been hot-bent into a 3D shape.

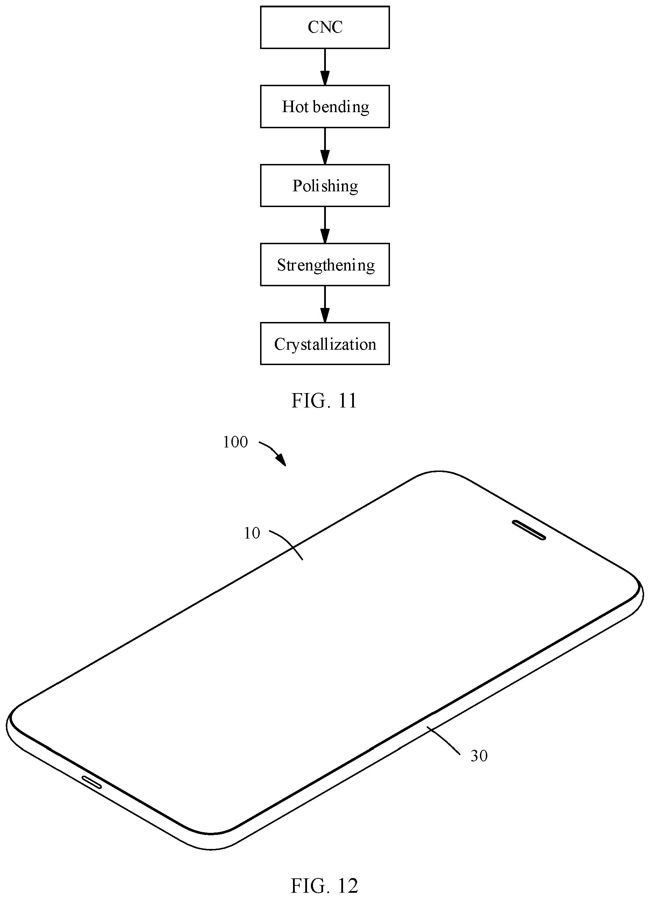

In some embodiments of this application, as shown in FIG. 10, the method for preparing glass mainly includes the following processes in sequence: CNC, hot bending, polishing, crystallization, and strengthening. In some other embodiments of this application, as shown in FIG. 11, the method for preparing glass mainly includes the following processes in sequence: CNC, hot bending, polishing, strengthening, and crystallization. That is, the crystallization process may be performed before or after the strengthening treatment. That is, the crystallization process may be to perform chemical strengthening treatment on the uncrystallized glass precursor, or to perform chemical strengthening treatment on the crystallized glass precursor.

In addition, in the processes shown in FIG. 10 and FIG. 11, the crystallization process is performed after the hot bending. In some embodiments, the crystallization process may alternatively be performed before the hot bending. That is, the hot bending process may be to perform hot bending on the uncrystallized glass precursor, or to perform hot bending on the crystallized glass precursor. Therefore, in the method for preparing glass, the crystallization process of glass crystallization induced by the femtosecond laser may be performed before or after the hot bending based on a crystal type, a hot bending molding temperature, and a chemical strengthening level, or may be performed before or after the strengthening treatment based on the crystal type, the hot bending molding temperature, and the chemical strengthening level.

It should be noted that a method for manufacturing a conventional 3D glass-ceramic cover includes: first performing thermal treatment and nucleation and crystallization on a glass precursor to obtain glass-ceramics, and then performing hot bending 3D molding on the glass-ceramics. That is, in the conventional 3D glass-ceramic cover, hot bending molding is performed after crystal precipitation of the glass-ceramics. During the hot bending process, it is easy to cause growth of a crystalline phase size, a crystallinity change, or even a phase change, resulting in sharp deterioration of optical properties of the glass (absolute value of a color difference b ≥ 2, and haze ≥ 0.25%) and size fluctuation. Therefore, the existing glass-ceramics and the preparation method thereof cannot meet the application of 3D covers.

In the method for preparing glass according to the embodiment of this application, when the crystallization process is performed after the hot bending, the glass-ceramics are not nucleated during hot bending molding, which can resolve the problems of the growth of the crystalline phase size and optical property deterioration of the 3D glass-ceramics cover during hot bending. In this way, stability of 3D hot bending molding of the glass can be improved.

In some embodiments of this application, the strengthening treatment includes two ion exchanges: the first ion exchange: a composition of a molten salt being pure NaNO₃ or a NaNO₃/KNO₃ mixture, with content of NaNO₃ ≥ 50wt% (such as 50wt%~60wt%, 60wt%~70wt%, 70wt%~80wt%, 80wt%~90wt%, or 90wt%~100wt%), and the molten salt being at a temperature of 380°C~450°C (such as 380°C~390°C, 390°C~400°C, 400°C~410°C, 410°C~420°C, 420°C~430°C, 420°C~430°C, 430°C~440°C, or 440°C~450°C); and the second ion exchange: a composition of a molten salt being pure KNO₃ or a NaNO₃/KNO₃ mixture, with content of KNO₃ ≥ 80wt% (such as 80wt%~85wt%, 85wt%~90wt%, 90wt%~95wt%, or 95wt%~100wt%), and the molten salt being at a temperature of 380°C~450°C (such as 380°C~390°C, 390°C~400°C, 400°C~410°C, 410°C~420°C, 420°C~430°C, 430°C~440°C, or 440°C~450°C).

Preferably, in the first ion exchange, the composition of the molten salt is a NaNO₃/KNO₃ mixture, with the content of NaNO₃ being 70wt%~100wt%, and the molten salt being at a temperature of 400°C~430°C. In the second ion exchange, the composition of the molten salt is a NaNO₃/KNO₃ mixture, with the content of KNO₃ being 85wt%~100wt%, and the molten salt being at a temperature of 400°C~420°C.

The method for preparing glass is described in detail below.
(1) CNC. Specifically, before CNC machining, the method further includes forming a glass matrix by using one of a melt casting method, a rolling method, a float method, an overflow method, and a sintering method. Then cutting/grinding/polishing is performed on the glass matrix to obtain a raw glass sheet. The cutting may be implemented through carving by a numerical control machine to obtain a required shape, size, and chamfer of the glass. After cutting, grinding/polishing needs to be performed to make the surface smooth. Polishing leather, a brush, a sponge polishing disk, and the like may be used in combination with polishing powder for rough grinding and fine grinding. In some embodiments, after cutting/grinding/polishing is performed on the glass matrix, a raw glass sheet with a thickness of 0.7 mm is obtained.
(2) Hot bending. Specifically, the raw glass sheet is placed in a 3D graphite mold, and the raw glass sheet is bent in a hot bending machine for 3D molding. In some embodiments, hot bending is performed at a maximum temperature of 750°C, a hot bending molding pressure of 0.9 MPa, and a single-station hot bending time of 60s. The purpose of hot bending molding is to obtain glass with a required 3D shape.
(3) Polishing. Specifically, concave and convex surfaces of the glass after 3D molding are ground and polished. In some embodiments, the concave and convex surfaces of the glass after 3D molding are polished by using a large disk polishing machine, where the concave surface is polished by a brush + a sponge for 60 min, and the convex surface is polished by the brush + the sponge for 30 min.
(4) Crystallization. Specifically, the polished glass is fixed on a three-dimensional platform, and internal crystallization of the glass is induced by a femtosecond laser. In some embodiments, a femtosecond laser pulse with a wavelength of 1030 nm, a pulse width of 370 fs, a repetition frequency of 500 kHz, and an average power of 1500 mW is focused inside the glass by using a 50× objective lens (NA=0.8) to induce the generation of a glass-ceramic layer. A macroscopic morphology of the glass-ceramic layer can be adjusted by using a laser path to prevent cracks or defects from expanding along the interface between the glass-ceramic layer and the outer surface glass phase layer, so as to improve glass performance. In addition, through further shifting of the laser path, the glass-ceramic layer can be shifted to a position far away from a thickness center of the glass, so that the glass-ceramics have a high fracture toughness and are conductive to chemical strengthening.
(5) Strengthening. Specifically, the crystallized glass is placed in pure NaNO₃ or a NaNO₃/KNO₃ mixed salt (the content of NaNO₃ is greater than or equal to 50wt%; for example, the content of NaNO₃ is 50wt%~60wt%, 60wt%~70wt%, 70wt%~80wt%, 80wt%~90wt%, or 90wt%~100wt%) for the first strengthening for 0.5~6 h (such as 0.5~1 h, 1~2 h, 2~3 h, 3~4 h, 4~5 h or 5~6 h) at a strengthening temperature of 380°C~450°C (such as 380°C~390°C, 390°C~400°C, 400°C~410°C, 410°C~420°C, 420°C~430°C, 420°C~430°C, 430°C~440°C, or 440°C~450°C); and then pure KNO₃ or a NaNO₃/KNO₃ mixed salt (the content of KNO₃ is greater than or equal to 80wt%, such as 80wt%~85wt%, 85wt%~90wt%, 90wt%~95wt%, or 95wt%~100wt%) for the second strengthening for 0.2~1 h (such as 0.2~0.5 h, 0.5~0.8 h or 0.8~1 h) at a strengthening temperature of 380°C~450°C (such as 380°C~390°C, 390°C~400°C, 400°C~410°C, 410°C~420°C, 420°C~430°C, 420°C~430°C, 430°C~440°C, or 440°C~450°C). Preferably, the first strengthening is performed for 2~3 h, and the second strengthening is performed for 0.5~1 h.

In some embodiments, the first strengthening is performed for 3 h at a strengthening temperature of 430°C by using pure NaNO₃; and the second strengthening is performed for 1 h at a strengthening temperature of 420°C by using a NaNO₃/KNO₃ mixed salt, where the content of KNO₃ is 99wt%. It can be understood that, in the foregoing method for preparing glass, some steps may be exchanged, combined, or omitted.

In the method for preparing glass according to the embodiments of this application, the uncrystallized glass precursor is used, and the near infrared femtosecond laser pulse with a high repetition frequency is focused into the glass precursor to implement nucleation and crystallization, so that compared with common glass-ceramics, the prepared glass has better 3D molding stability and surface processability, is suitable for chemical strengthening, and has both a high fracture toughness of glass-ceramics and a deep chemical strengthening level of glass. When being applied to an electronic device as a cover or a housing, the glass has excellent anti-drop performance. In some embodiments, the cover made of the foregoing glass is mounted on a mobile phone with a weight of 200 g (including the weight of the cover), and when the mobile phone falls with the cover-mounted surface facing downward, the cover can pass a test of dropping on marble or a 180-mesh sandpaper ground at a drop height of 1.5 m.

Therefore, the foregoing method for preparing glass resolves the technical problems in processing (such as hot bending, cleaning, strengthening, and coating with an anti-fingerprint film) of the 3D glass-ceramic cover, the femtosecond laser is used to induce crystallization to form a structure in which a glass phase layer and a glass-ceramic phase layer are sequentially provided from the surface layer to the inside, and the complete glass phase layer at the surface layer is used to perform processing such as hot bending, cleaning, strengthening, and coating with an anti-fingerprint film. The glass phase layer at the surface layer has high Na/K exchange efficiency during chemical strengthening, which improves a stress of a K layer and a depth of the K layer. The stress of the K layer and the depth of the K layer are monitored by using a film stress measurement (Film Stress Measurement, FSM) instrument, and the glass phase layer has better scratch resistance. In addition, the glass phase layer can improve chemical resistance, adhesion of the anti-fingerprint film, and aging test performance. In addition, when crystallization is being performed after hot bending, the problems such as crystalline phase size growth and deterioration of optical properties of the 3D glass-ceramics during hot bending can be further resolved.

In some embodiments of this application, a glass member (not shown) is further provided. The glass member includes the foregoing glass. In some embodiments, the glass member further includes an anti-fingerprint film and/or a decorative layer arranged on a surface of the glass. The anti-fingerprint film may be arranged on a side of an appearance surface of the glass member. The decorative layer may be ink, which may be arranged on a side opposite to the appearance surface of the glass member. It can be understood that the glass member may further include another functional film layer arranged on the surface of the glass, for example, an anti-reflection film, which is not limited herein. Specifically, the glass member may be a screen cover and/or a housing of an electronic device (including a mobile phone, a tablet computer, a computer, a navigation system, or the like). Alternatively, the glass member is applied to: another device with glass, such as a building product (for example, building glass); a vehicle product (for example, a windshield or in-vehicle dashboard glass), an appliance product, or any product that requires a certain degree of transparency, scratch resistance, and abrasion resistance or a combination thereof.

In some embodiments of this application, a method for preparing a glass member is further provided, where the method includes the foregoing method for preparing glass. In addition, the method for preparing a glass member further includes: cleaning the polished glass precursor with an alkaline solution, and/or arranging an anti-fingerprint film and/or a decorative layer on a surface of the glass. Because a surface layer of the foregoing glass is a complete glass phase layer, compared with conventional glass-ceramics (that is, the surface layer includes a glass phase and a microcrystalline phase), glass hazing and micro-surface quality degradation caused by erosion and reaction due to a large difference in physical and chemical properties of a crystalline phase and an amorphous phase can be prevented, and the anti-fingerprint film and/or the decorative layer have/has good adhesion.

In some embodiments of this application, an electronic device member is further provided. As shown in FIG. 12, the electronic device 100 includes a screen cover 10 and a housing 30. The screen cover 10 and the housing 30 cooperatively accommodate functional modules (not shown) of the electronic device 100, such as a display touch panel, a battery, a circuit board, and a chip. At least one of the screen cover 10 and the housing 30 includes the foregoing glass. In FIG. 12, that the electronic device 100 is a mobile phone is used as an example, but the electronic device 100 is not limited to the mobile phone, and may alternatively be a tablet computer, a computer, a watch, a navigation system, or the like.

## Claims

1. An electronic device (100), comprising a screen cover (10) and a housing (30), wherein at least one of the screen cover (10) and the housing (30) comprises a glass,
wherein the glass comprises glass phase layers that is located on a surface layer of the glass and comprises no crystal, and a glass-ceramic layer that is stacked with the glass phase layers and comprises crystals;
wherein the glass is a glass sheet, and the glass comprises two glass phase layers in a thickness direction of the glass; and the glass-ceramic layer is located between the two glass phase layers.

2. The electronic device (100) according to claim 1, wherein the crystals have a size of 5 nm~1 µm.

3. The electronic device (100) according to claims 1 or 2, wherein a main crystalline phase in the glass-ceramic layer comprises one or more of lithium silicate, a β-quartz solid solution, lithium disilicate, petalite, and a β-spodumene solid solution.

4. The electronic device (100) according to any one of claims 1 to 3, wherein the glass phase layer comprises one or more of Li₂O, Na₂O, and K₂O, and a sum of weight percentages of Li₂O, Na₂O, and K₂O in the glass is 5%~18%.

5. The electronic device (100) according to any one of claims 1 to 4, wherein the glass-ceramic layer has a thickness less than or equal to 50 µm.

6. The electronic device (100) according to any one of claims 1 to 5, wherein the glass-ceramic layer has a crystallinity greater than 80%, and the glass-ceramic layer has a Young's modulus greater than or equal to 90 GPa.

7. The electronic device (100) according to any one of claims 1 to 6, wherein the glass has a 2D shape, a 2.5D shape, or a 3D shape.

8. The electronic device (100) according to any one of claims 1 to 7, wherein a thickness of the glass is defined as t, and t is 0.1~1 mm.

9. The electronic device (100) according to claim 8, wherein the glass-ceramic layer has a thickness greater than or equal to 0.99t; or the glass-ceramic layer has a thickness of 0. 5t~0.9t.

10. The electronic device (100) according to claim 8 or 9, wherein the glass has a depth of a chemically strengthened layer of 3~10 µm, the glass has a depth of compression of 0.14t~0.23t, and the glass has a surface compressive stress of 600~1000 Mpa.

## Patentansprüche

1. Ein elektronisches Gerät (100), umfassend eine Bildschirmabdeckung (10) und ein Gehäuse (30), wobei mindestens eine der Bildschirmabdeckung (10) und das Gehäuse (30) ein Glas umfasst,
wobei das Glas Glasschichtphasen umfasst, die sich auf einer Oberflächenschicht des Glases befinden und keine Kristalle enthalten, und eine Glaskeramikschicht, die mit den Glasschichtphasen gestapelt ist und Kristalle enthält;
wobei das Glas eine Glasscheibe ist und das Glas in einer Dickenrichtung des Glases zwei Glasschichtphasen umfasst; und die Glaskeramikschicht zwischen den beiden Glasschichtphasen angeordnet ist.

2. Das elektronische Gerät (100) nach Anspruch 1, wobei die Kristalle eine Größe von 5 nm bis 1 µm aufweisen.

3. Das elektronische Gerät (100) nach Anspruch 1 oder 2, wobei eine Hauptkristallphase in der Glaskeramikschicht eine oder mehrere der folgenden umfasst: Lithiumsilikat, eine β-Quarz-Festlösung, Lithiumdisilikat, Petalit und eine β-Spodumen-Festlösung.

4. Das elektronische Gerät (100) nach einem der Ansprüche 1 bis 3, wobei die Glasschichtphase eine oder mehrere der folgenden umfasst: Li₂O, Na2O und K2O, und die Summe der Gewichtsprozentsätze von Li₂O, Na2O und K2O im Glas 5 % bis 18 % beträgt.

5. Das elektronische Gerät (100) nach einem der Ansprüche 1 bis 4, wobei die Glaskeramikschicht eine Dicke von höchstens 50 µm aufweist.

6. Das elektronische Gerät (100) nach einem der Ansprüche 1 bis 5, wobei die Glaskeramikschicht eine Kristallinität von mehr als 80 % aufweist und die Glaskeramikschicht einen Elastizitätsmodul von mindestens 90 GPa aufweist.

7. Das elektronische Gerät (100) nach einem der Ansprüche 1 bis 6, wobei das Glas eine 2D-Form, eine 2,5D-Form oder eine 3D-Form aufweist.

8. Das elektronische Gerät (100) nach einem der Ansprüche 1 bis 7, wobei eine Dicke des Glases als t definiert ist und t 0,1 bis 1 mm beträgt.

9. Das elektronische Gerät (100) nach Anspruch 8, wobei die Glaskeramikschicht eine Dicke von mindestens 0,99t aufweist; oder die Glaskeramikschicht eine Dicke von 0,5t bis 0,9t aufweist.

10. Das elektronische Gerät (100) nach Anspruch 8 oder 9, wobei das Glas eine Tiefe einer chemisch verstärkten Schicht von 3 bis 10 µm aufweist, das Glas eine Drucktiefe von 0,14t bis 0,23t aufweist und das Glas eine Oberflächendruckspannung von 600 bis 1000 MPa aufweist.

## Revendications

1. Un dispositif électronique (100), comprenant un couvercle d'écran (10) et un boîtier (30), où au moins l'un du couvercle d'écran (10) et du boîtier (30) comprend un verre,
où le verre comprend des couches de phase vitreuse situées sur une couche de surface du verre et ne contenant aucun cristal, et une couche de verre-céramique empilée avec les couches de phase vitreuse et contenant des cristaux ;
où le verre est une feuille de verre, et le verre comprend deux couches de phase vitreuse dans une direction d'épaisseur du verre ; et la couche de verre-céramique est située entre les deux couches de phase vitreuse.

2. Le dispositif électronique (100) selon la revendication 1, où les cristaux ont une taille de 5 nm~1 µm.

3. Le dispositif électronique (100) selon les revendications 1 ou 2, où une phase cristalline principale dans la couche de verre-céramique comprend un ou plusieurs des éléments suivants : silicate de lithium, solution solide de β-quartz, disilicate de lithium, pétalite et solution solide de β-spodumène.

4. Le dispositif électronique (100) selon l'une quelconque des revendications 1 à 3, où la couche de phase vitreuse comprend un ou plusieurs des éléments suivants : Li₂O, Na2O et K₂O, et une somme des pourcentages en poids de Li₂O, Na2O et K2O dans le verre est de 5 %~18 %.

5. Le dispositif électronique (100) selon l'une quelconque des revendications 1 à 4, où la couche de verre-céramique a une épaisseur inférieure ou égale à 50 µm.

6. Le dispositif électronique (100) selon l'une quelconque des revendications 1 à 5, où la couche de verre-céramique a une cristallinité supérieure à 80 %, et la couche de verre-céramique a un module de Young supérieur ou égal à 90 GPa.

7. Le dispositif électronique (100) selon l'une quelconque des revendications 1 à 6, où le verre a une forme 2D, une forme 2.5D ou une forme 3D.

8. Le dispositif électronique (100) selon l'une quelconque des revendications 1 à 7, où une épaisseur du verre est définie comme t, et t est de 0.1~1 mm.

9. Le dispositif électronique (100) selon la revendication 8, où la couche de verre-céramique a une épaisseur supérieure ou égale à 0.99t ; ou la couche de verre-céramique a une épaisseur de 0.5t~0.9t.

10. Le dispositif électronique (100) selon la revendication 8 ou 9, où le verre a une profondeur d'une couche renforcée chimiquement de 3~10 µm, le verre a une profondeur de compression de 0.14t~0.23t, et le verre a une contrainte de compression de surface de 600~1000 Mpa.
